# EUROPEAN PATENT APPLICATION

(11) **EP 4 766 041 A1**
(43) Date of publication of application: **24.06.2026**
(21) Application number: 25223169.1
(22) Date of filing: 12.12.2025
(51) Int. Cl.: H05K 5/02, C25D 11/00

(54) **AN ELECTRONIC APPARATUS WITH THERMAL PROTECTION**

(30) Priority: 19.12.2024 IN 202441100718
(71) Applicant: Valeo eAutomotive Germany GmbH, 91056 Erlangen (DE)
(72) Inventor: RAJKAMARAJAR, Subasree, 600130 Navalur, Chennai (IN); SAGAYARAJ, Robert, 600130 Navalur, Chennai (IN); DORAIRAJ, Deepan, 600130 Navalur, Chennai (IN); RAVICHANDRAN, Balaji, 600130 Navalur, Chennai (IN); MADHAVAN, Prasath, 600130 Navalur, Chennai (IN)
(74) Representative: Valeo Powertrain Systems

(57) **Abstract**

The present subject matter relates to an electronic apparatus (100) that includes an internal circuitry (102a; 102b) and a housing (104) defining an interior volume (108) in which the internal circuitry (102a; 102b) is disposed. The housing (108) includes at least one surface (110a; 110b; 110c; 110d; 111a; 111b; 111c; 111d) formed from a metal substrate (202). An anodized layer (112a; 112b; 112c; 112d) is formed on at least one surface (110a; 110b; 110c; 110d; 111a; 111b; 111c; 111d). This anodized layer (112a; 112b; 112c; 112d) includes a plurality of pores within which fire retardant polymer material (116) is disposed. The present subject matter relates also to a method of manufacturing the electronic apparatus (100).

## Description

### FIELD OF INVENTION

The present subject matter relates to the field of electronics, specifically relating to an electronic apparatus enhanced with thermal protection.

### BACKGROUND

Electronic apparatuses, especially those operating at high power or in thermally challenging environments, are constantly exposed to heat generation. This heat, if not effectively managed, can lead to a range of issues, from performance degradation to critical safety hazards. A 'thermal event', in this context, refers to a situation where excessive heat results in undesirable consequences, such as, components exceeding their safe operating temperatures, leading to reduced lifespan and potentially malfunction. In extreme cases, this can escalate to thermal runaway, a cascading effect where rising temperatures cause further heat generation, potentially resulting in catastrophic failure. Moreover, there is a risk of fire hazards, where excessive heat can ignite flammable materials within the apparatus or in its surrounding.

Conventional approaches to mitigating thermal event typically involve heat sinks to absorb and dissipate heat; fans and blowers, which enhance convective cooling; and thermal interface material, which improve heat transfer between components. However, these approaches often fall short in providing comprehensive thermal protection, especially in demanding applications. They require space, add weight, and may not be sufficient to prevent thermal runaway or fire hazards in extreme conditions.

Therefore, the technical problem to be solved by the present subject matter is how to provide an electronic apparatus with enhanced thermal protection that effectively mitigates the risk of thermal events, including overheating, thermal runaway, and fire hazards, while maintaining compactness, lightweight design, and cost-effectiveness.

### SUMMARY OF THE INVENTION

The present subject matter seeks to solve the above-mentioned technical problem in conventional housing for electronic equipment defined by an internal circuitry.

According to the present subject matter, electronic apparatus comprising: an internal circuitry; and a housing defining an interior volume and having at least one surface formed from a metal substrate, the internal circuitry being disposed within the interior volume, wherein an anodized layer formed on at least one surface of the metal substrate, the anodized layer comprising a plurality of pores; and fire-retardant polymer material disposed within the plurality of pores of the anodized layer. Accordingly, the electronic apparatus has enhanced thermal protection. The fire retardant polymer material effectively mitigates the risk of thermal events, such as a fire spreading. Accordingly, the internal circuitry is protected from damage by such a thermal event.

According to an example of the present subject matter, the fire retardant polymer material comprises at least one of: a brominated flame retardant; an aluminum trihydrate retardant; and a combination thereof.

According to an aspect of the present subject matter, the fire retardant polymer material is infused into the plurality of pores. The fire retardant polymer is either partially filled in the plurality of pores, or completely filled in the plurality of pores. In the scenario where the fire retardant polymer material is fully filled within the plurality of pores, there is enhanced protection of the internal circuitry from thermal events. In the scenario where the fire retardant polymer material if partially filled within the plurality of pores, there is significant improvement in fire retardant properties while offering advantages such as reduced material usage, faster processing times, or maintaining a certain level of breathability within the housing.

According to an example of the present subject matter, the metal substrate comprises aluminum or an aluminum alloy. These materials are suitably reliable for forming the housing that encloses the internal circuitry.

According to an aspect of the present subject matter, the at least one surface comprises an exterior surface of the housing and an interior surface of the housing, wherein the anodized layer is formed on the exterior surface, or the interior surface or both the exterior surface and interior surface of the housing.

According to an example of the present subject matter, the electronic apparatus is selected from the group consisting of an electric power converter, a DC-DC converter, an on board charger, and a battery management system.

The present subject matter relates also to a method of manufacturing the electronic apparatus, the method comprising: providing a housing having at least one surface formed from a metal substrate; anodizing the metal substrate to form an anodized layer having a plurality of pores; and infusing a fire retardant polymer material into the plurality of pores of the anodized layer.

According to an aspect of the present subject matter, the step of infusing the fire retardant polymer material comprises immersing the metal substrate in a bath containing the fire retardant polymer material.

According to an aspect of the present subject matter, the method comprises, prior to anodizing: cleaning the metal substrate; etching the metal substrate; and desmutting the metal substrate.

According to an aspect of the present subject matter, the method comprises sealing the anodized layer.

In accordance with an example of the present subject matter, the electronic apparatus, configured in accordance with the description above, is an electronic power converter configured to converter direct current (DC) to alternating current (AC) and/or vice versa. In accordance with yet another example of the present subject matter, the electronic apparatus, configured in accordance with the description above, is a DC-DC converter or an on board charger.

Accordingly, by virtue of the fire retardant polymer material, the internal circuitry of the electronic apparatus is protected from thermal events.

### BRIEF DESCRIPTION OF DRAWINGS

The features, aspects, and advantages of the present invention will be better understood with regard to the following description and accompanying figures. The description refers to the annexed drawings, wherein:
FIG. 1A is a schematic illustration of an electronic apparatus with enhanced fire retardancy, configured in accordance with the present subject matter;
FIG. 1B illustrates particularly a region A, shown in FIG. 1A, configured in accordance with an aspect of the present subject matter;
FIG. 2A illustrates a metal substrate and various configurations of said metal substrate to form a housing for the electronic apparatus, configured in accordance with an example of the present subject matter; and
FIG. 2B illustrates a flowchart depicting a method of manufacturing the electronic apparatus, configured in accordance with the present subject matter.

The figures are not necessarily to scale, and the size of some parts may be exaggerated to more clearly illustrate the example shown. Moreover, the drawings provide examples and/or examples consistent with the description, however, the description is not limited to the examples and/or examples provide in the drawings.

### DETAILED DESCRIPTION

In the description that follows, reference is made to accompanying drawings, which form part thereof, and in which is shown by way of illustration specific implementations in which the invention maybe practiced. These implementations are described in sufficient detail to enable that skilling in the art to practice the invention, and it is to be understood that the implementations may be combined, or that other implementations may be utilized, and that structural and logical changes may be made without departing from the scope of the present invention. The following detailed description is, therefore, not to be taken in a limiting sense, and the scope of the present invention is defined by the appended claims and their equivalents.

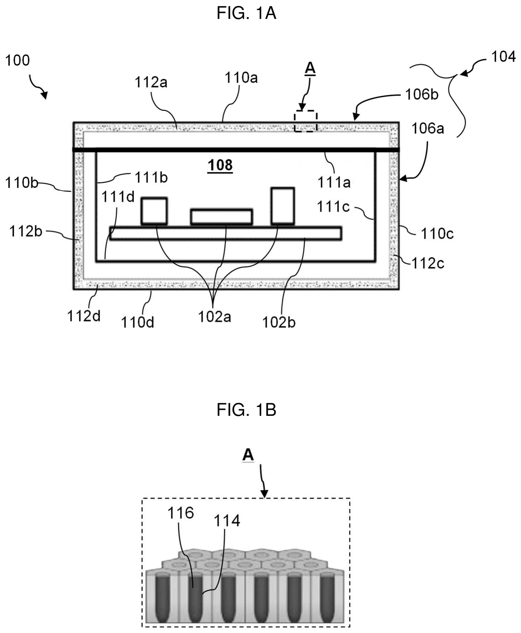

FIG. 1A is a schematic illustration of an electronic apparatus 100 with enhanced fire retardancy, configured in accordance with the present subject matter. FIG. 1B illustrates particularly a region **A,** shown in FIG. 1A, of the electronic apparatus, wherein fire retardant polymer material is disposed in plurality of pores, in accordance with an aspect of the present subject matter. The description that follows pertain to the aforementioned figures in tandem.

The present subject matter relates to an electronic apparatus 100 that includes a housing 104 and an internal circuitry 102a, 102b disposed within an inner volume 108 of the housing 104. The housing has at least one surface 110a, 110b, 110c, 110d, 111a, 111b, 111c, 111d (herein '110a-d, 111a-d' for the sake of brevity) formed from a metal substrate. An anodized layer 112a, 112b, 112c, 112d (herein '112a-d' for the sake of brevity) is formed on at least one surface 110a-d, 111a-d of the metal substrate. The anodized layer 112a-d includes a plurality of pores 114 within which fire retardant polymer material 116 is disposed.

According to an aspect of the present subject matter, the fire retardant polymer material 116 has properties to provide flame retardancy and electrical insulation to the housing 104.

In FIG. 1A, the housing 104 is divided into a casing 106a and a cover 106b. The casing 106a is provided with the internal volume 108 with an opening (not shown) through which the internal circuitry 102a, 102b is disposed. The cover 106b encloses this opening of the casing 106a thereby forming the housing 104 in which the internal circuitry 102a, 102b. The internal circuitry 102a, 102b may include various electronic components 102a fixed (or, soldered) onto an electronic board 102b. The casing 106a and/or cover 106b is formed from the metal substrate. The metal substrate is, for instance, made of aluminum, an alloy of aluminum, or any material suitable for housing electric circuitry 102a, 102b. The anodized layer 112a-d, shown in FIG. 1A, is an example in which said anodized layer 112a-d is exposed to an outer environment of the electronic apparatus 100. The outer environment here refers to the space outside the housing 104. Alternatively, this anodized layer is provided to be exposed to the interior volume 108 of the housing 104. In yet another alternate manner, the anodized layer is provided such that it is exposed to both the interior volume 108 and the outer environment of the electronic apparatus.

According to an aspect of the present subject matter, the at least one surface 110a, 110b, 110c, 110d, 111a, 111b, 111c, 111d of the housing 104 includes exterior surfaces 110a, 110b, 110c, 110d that are exposed to the outer environment of said housing 104, and interior surfaces 111a, 111b, 111c, 111d that are exposed to the interior volume 108 of the housing 104. In the example shown in FIG. 1A, the anodized layer 112a; 112b; 112c; 112d is provided on the external surfaces 110a, 110b, 110c, 110d of the housing 104. Accordingly, the plurality of pores 116 (shown in FIG. 1B) is formed on the external surfaces 110a, 110b, 110c, 110d, and the fire-retardant polymer material 116 being disposed therein.

In an alternate example (not shown), the anodized layer is formed on the interior surfaces 111a, 111b, 111c, 111d. Accordingly, the aforementioned anodized layer include the plurality of pores 114, formed on the interior surfaces 111a, 111b, 111c, 111d, provided with fire retardant polymer material 116 disposed therein.

In yet an alternate example (not shown), the anodized layer is formed on both the exterior surfaces 110a, 110b, 110c, 110d and the interior surfaces 111a, 111b, 111c, 111d. Thus, fire-retardant polymer material 116 is disposed in the plurality of pores 114 of the anodized layer formed on both the exterior surfaces 110a, 110b, 110c, 110d and the interior surfaces 111a, 111b, 111c, 111d.

According to an aspect of the present subject matter, the casing 106a includes multiple surfaces, and an open end which is closed by the cover 106b. For the sake of simplicity in illustration the casing 106a shown is a box shape with the open end being covered by the cover 106. It is important to note that while the depicted casing is represented as a box, the casing 106a may take on various shapes designed to accommodate the internal circuitry 102a, 102b housed within. The specific configuration of the casing 106a will be adapted to suit the environmental conditions in which the electronic apparatus 100 is assembled. Consequently, the cover 106b will be shaped to complement the open end of the casing 106a, ensuring a secure and functional fit regardless of the casing's 106a shape.

The casing 106a shown in FIG. 1A, as explained in the foregoing paragraph, is a simplified schematic. FIG. 1A shows a perspective of the casing 106a depicting three external surfaces 110b, 110c, 110d that are exposed to the outer environment, and three internal surfaces 111a, 111c, 111d that are exposed to the inner volume 108 and disposed opposite to the three surfaces 110b, 110c, 110d respectively. Further, the cover 106b, in FIG. 1A, shows a surface 110a exposed to the outer environment, and a surface 111a exposed to the inner volume 108 and disposed opposite to the surface 110a. In the example shown, the three external surfaces 110b, 110c, 110d of the casing 106a is provided with the anodized layer 112b, 112c, 112d respectively. Therefore, fire retardant polymer material 116 is disposed within the plurality of pores 114 in said anodized layer 112b, 112c, 112d of the casing 106a. Further, the external surface 110a of the cover 106b is provided with the anodized layer 112a wherein the plurality of pores 114 is formed and fire retardant polymer material 116 is disposed therein.

According to the aspect shown in FIG. 1B, the plurality of pores 114 is filled with the fire retardant polymer material 116. In the aforementioned configuration, the fire retardant polymer material 116 may function as a fire retardant to arrest a thermal event, such as fire, from spreading. Moreover, the fire retardant polymer functions as a sealant in said configuration where it fully fills in the plurality of pores 114.

Alternatively, the plurality of pores 114 is partially filled with the fire retardant polymer material 116. The fire retardant polymer material 116 may, for instance, be infused into the plurality of pores 114. In the scenario where fire retardant polymer material 116 is partially filled, a seal is provided to close the plurality of pores 114.

According to an example, the fire retardant polymer material 116 includes brominated flame retardant, or aluminum trihydrate retardant, or a combination thereof.

The electronic apparatus 100 configured in accordance with the present subject matter may be an electric power converter configured to convert direct current (DC) to alternating current (AC) and/or vice versa. Accordingly, in said example, the housing 104 is for the electric power converter. The electronic apparatus 100 is alternatively a DC-DC converter, or an on board charger, or a battery management system, etc. The housing 104, described in accordance with the present subject matter, accommodates the internal circuitry 102a, 102b that electrically interacts or communicates to a global circuitry of a motor vehicle being driven by an internal combustion engine or a mild, hybrid, or purely electric drive. Therefore, the electronic apparatus 100 may be an electric power converter, DC-DC converter, on board charger or battery management system. The housing 104, configured in accordance with the present subject matter, for the aforementioned examples of electronic apparatuses 100 is thus effective in mitigating thermal events. Such a housing 104 ensures thermal protection of the internal circuitry 102a, 102b.

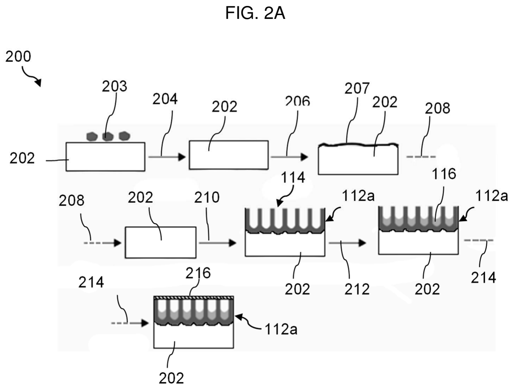

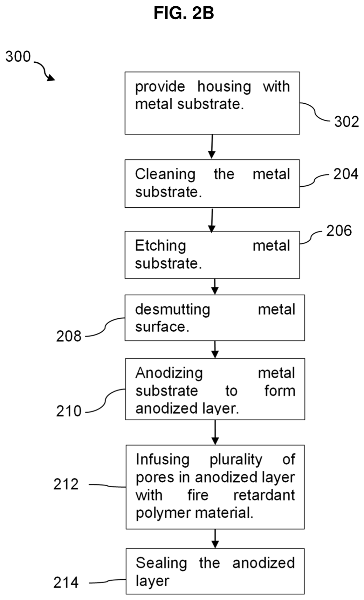

FIG. 2A illustrates a metal substrate 202 and its various configurations to form the housing 104 for the electronic apparatus 100, configured in accordance with an aspect of the present subject matter. FIG. 2B is a flowchart depicting a method 200 of manufacturing the electronic apparatus 100, in accordance with the present subject matter. In particular, FIG. 2A shows the metal substrate 202 and its configuration after having gone through one or more of the step(s) in the method 200 shown in FIG. 2B. Further, FIG. 2A shows arrows that indicate one of the step(s) from the method 200.

According to the present subject matter, the method 300 firstly includes a step of providing 302 the housing 104 having at least one surface 110a-d, 111a-d, that is formed from a metal substrate 202. The next step in the method 300 includes anodizing 210 the metal substrate 202 thereby forming the anodized layer 112a having plurality of pores 114. Further, the method 300 includes infusing 212 fire retardant polymer material 116 into the plurality of pores 114 of the anodized layer 112a.

For the sake of simplicity in description of the present subject matter, the metal substrate 202 shown in FIG. 2A is of the external surface 110a. Therefore, the anodized layer 112a shown in FIG. 2A is of the external surface 110a of the cover 106b. However, it is to be understood that the configuration of the metal substrate 202 and the method 300 steps described herein is applicable for any one or all surfaces 110a-d, 111a-d of the housing 104.

According to an example, the infusing 212 of fire retardant polymer material 116 includes immersing the metal substrate 202, that has been anodized 210, in a bath containing the fire retardant polymer material 116. This bath may include brominated flame retardant, or aluminum trihydrate retardant, or a combination thereof. The degree to which the fire retardant polymer material 116 fills the plurality of pores 114 of the anodized layer 112a can be controlled depending on the desired properties and application. In one scenario, the fire retardant polymer material 116 fully fills the plurality of pores 114, creating a continuous layer within the anodized layer 112a. This complete filing can provide a higher level of fire resistance and a more uniform surface finish. Alternatively, the fire retardant polymer material 116 may only partially fill the plurality of pores 114, as illustrated in FIG. 2A. This partial filling can still provide significant fire retardant properties while potentially offering advantages such as reduced material usage, faster processing times, or maintaining a certain level of breathability within the housing 104.

According to an example of the present subject matter, the method 300 includes a step of cleaning 204 the metal substrate 202. The aforementioned step of cleaning 204 is performed to rid the metal substrate 202 from any contaminants 203, thereby preparing the metal substrate 202 for another step in the method 300. Particularly, the step of cleaning 204 removes any contaminants, such as dirt, grease, or oxides, that could interfere with the step of anodizing 210. The method 300 further includes a etching 206 the metal substrate 202 with an appropriate chemical solution to further prepare it for anodization 210. Etching 206 can roughen the metal substrate's 202 surface slightly. This rough surface 207 increases the surface area of the metal substrate 202 and improve adhesion of the anodized layer 112a. Further, in the method 300 is the step of desmutting 208 wherein any residues (or smut), left behind from etching 206, is removed. Desmutting 208 typically involves a chemical treatment to dissolve these residues, ensuring that the metal substrate 202 can undergo optimal anodization 210. The steps of cleaning 204, etching 206, desmutting 208 are for instance performed in succession of each other before the step of anodizing 210.

According to an example of the present subject matter, the method 300 includes sealing 214 the anodized layer 112a. After the fire retardant polymer material 116 is infused, the anodized layer 112a can be sealed. Sealing 214 closes the plurality of pores 114 of the anodized layer 112a, trapping the fire retardant polymer material within and providing a smoother, more durable surface. Sealing 214 can be achieved through various methods, such as hot water sealing, chemical sealing, or impregnation with a sealant material 216.

Various modifications of the disclosed embodiments, as well as alternate embodiments of the subject matter, will become apparent to persons skilled in the art upon reference to the description of the subject matter. It is therefore contemplated that such modifications can be made without departing from the scope of the present subject matter is defined.

## Claims

1. An electronic apparatus (100) comprising:
an internal circuitry (102a; 102b); and
a housing (104) defining an interior volume (108) and having at least one surface (110a; 110b; 110c; 110d; 111a; 111b; 111c; 111d) formed from a metal substrate (202), the internal circuitry (102a; 102b) being disposed within the interior volume (108), wherein
an anodized layer (112a; 112b; 112c; 112d) formed on at least one surface (110a; 110b; 110c; 110d; 111a; 111b; 111c; 111d) of the metal substrate, the anodized layer (112a; 112b; 112c; 112d) comprising a plurality of pores (114); and
a fire-retardant polymer material (116) disposed within the plurality of pores (114) of the anodized layer (112a; 112b; 112c; 112d).

2. The electronic apparatus (100) as claimed in claim 1, wherein the fire retardant polymer material (116) comprises at least one of:
a brominated flame retardant;
an aluminum trihydrate retardant; and
a combination thereof.

3. The electronic apparatus (100) as claimed in claim 2, wherein the fire retardant polymer material (116) is infused into the plurality of pores (114).

4. The electronic apparatus (100) as claimed in claim 1, wherein the metal substrate (202) comprises aluminum or an aluminum alloy.

5. The electronic apparatus (100) as claimed in claim 1, wherein the at least one surface (110a; 110b; 110c; 110d; 111a; 111b; 111c; 111d) comprises an exterior surface (110a; 110b; 110c; 110d) of the housing (104) and an interior surface (111a; 111b; 111c; 111d) of the housing (104), wherein
the anodized layer (112a; 112b; 112c; 112d) is formed on the exterior surface (110a; 110b; 110c; 110d), or the interior surface (111a; 111b; 111c; 111d) or both the exterior surface (110a; 110b; 110c; 110d) and interior surface (111a; 111b; 111c; 111d) of the housing (104).

6. The electronic apparatus as claim 1, wherein the electronic apparatus (100) is selected from the group consisting of an electric power converter, a DC-DC converter, an on board charger, and a battery management system.

7. A method (300) of manufacturing the electronic apparatus (100), the method (300) comprising:
providing (302) a housing (104) having at least one surface (110a; 110b; 110c; 110d) formed from a metal substrate (202);
anodizing (210) the metal substrate (202) to form an anodized layer (112a; 112b; 112c; 112d) having a plurality of pores; and
infusing (212) a fire retardant polymer material into the plurality of pores of the anodized layer (112a; 112b; 112c; 112d).

8. The method as claimed in claim 7, wherein infusing (212) the fire retardant polymer material (116) comprises immersing the metal substrate (202) in a bath containing the fire retardant polymer material (116).

9. The method as claimed in claim 7, comprising, prior to anodizing (210):
cleaning (204) the metal substrate (202);
etching (206) the metal substrate (202); and
desmutting (208) the metal substrate (202).

10. The method (300) as claimed in claim 7, comprising sealing (214) the anodized layer.
